# EUROPÄISCHE PATENTSCHRIFT

(11) **EP 0 691 543 B1**
(45) Veröffentlichungstag und Bekanntmachung des Hinweises auf die Patenterteilung: **19.03.2003**
(21) Anmeldenummer: 94110554.6
(22) Anmeldetag: 07.07.1994
(51) Int. Cl.: G01R 1/067, G01R 19/155

(54) **Gerät zum Prüfen und/oder Messen von elektrischen Grössen**
Device for testing and/or measuring electric variables
Appareil pour tester et/ou mesurer des variables électriques

(43) Veröffentlichungstag der Anmeldung: 10.01.1996
(73) Patentinhaber: Ch. Beha GmbH Technische Neuentwicklungen, D-79286 Glottertal (DE)
(72) Erfinder: Beha, Christian, D-79286 Glottertal (DE)
(74) Vertreter: Patentanwälte Westphal, Mussgnug & Partner

(56) Entgegenhaltungen:
- DE-A- 3 513 345
- DE-U- 8 909 511
- US-A- 2 778 992
- US-A- 2 783 445
- US-A- 4 238 728
- PATENT ABSTRACTS OF JAPAN vol. 7, no. 51 (P-179) (1196) 26. Februar 1983 & JP-A-57 198 871 (MATSUSHITA DENKO) 6. Dezember 1982

## Beschreibung

Die Erfindung betrifft ein Gerät zum Prüfen und/oder Messen von elektrischen Größen, insbesondere von Spannungen und/oder Widerständen gemäß dem Oberbegriff des Anspruchs 1.

Geräte dieser Art werden vorzugsweise als Spannungs- und/oder Durchgangsprüfer bei der Installation, Wartung und Reparatur von elektrischen Anlagen und Geräten eingesetzt. Die beiden Kontaktspitzen werden mit den elektrischen Polen, Adern, Anschlüssen oder Bauelementen in Berührung gebracht, zwischen denen die Spannung, der Widerstand oder der Durchgang geprüft bzw. gemessen werden soll. Die elektronische Prüf- und Meßschaltung, Anzeigeelemente und ggf. die Spannungsversorgung des Geräts sind in den Griffteilen angeordnet, vorzugsweise in einem Griffteil, welches hierzu als Gehäuse ausgebildet ist.

Geräte dieser Gattung werden häufig bei Montage- und Reparaturarbeiten außerhalb der Werkstatt mitgeführt. Werden die Geräte dabei in einer Werkzeugtasche oder Kiste mitgeführt, so sind die frei von den Griffteilen abstehenden Kontaktspitzen wenig störend. Müssen die Geräte jedoch in einer Kleidungstasche, Gürteltasche oder Gürtelschlaufe mitgeführt werden, so sind die frei abstehenden Kontaktspitzen für den Benutzer störend und es besteht sogar die Gefahr einer Verletzung. Auch können die Kontaktspitzen beschädigt werden.

Aus der US-A-2778992 ist ein Gerät bekannt, das in jedem seiner Griffteile neben der Kontaktspitze eine Aufnahme aufweist, in welche die Kontaktspitze des jeweils anderen Griffteils eingesteckt werden kann, wenn das Gerät nicht benutzt wird. In diesem zusammengesteckten Zustand ist jede der Kontaktspitzen durch das Griffteil der jeweils anderen Kontaktspitze geschützt. Der Benutzer kommt daher mit den Kontaktspitzen nicht mehr in Berührung, so daß die Kontaktspitzen dem Benutzer nicht lästig werden und ihn nicht verletzen oder seine Kleidung beschädigen können und so daß keine Gefahr besteht, daß die Kontaktspitzen verbogen, abgebrochen oder in sonstiger Weise beschädigt werden. Da die beiden Griffteile in antiparalleler Anordnung ihrer Kontaktspitzen zusammengesteckt werden, addieren sich bei dem zusammengesteckten Gerät die Längen der beiden Griffteile. Dadurch kann das zusammengesteckte Gerät unhandlich werden.

Der Erfindung liegt die Aufgabe zugrunde, ein Gerät der eingangs genannten Gattung zur Verfügung zu stellen, das von dem Benutzer platzsparend mitgeführt werden kann, ohne daß die Kontaktspitzen stören, eine Verletzungsgefahr verursachen oder beschädigt werden können.

Diese Aufgabe wird erfindungsgemäß gelöst durch ein Gerät mit den Merkmalen des Anspruchs 1.

Vorteilhafte Ausführungen der Erfindung sind in den Unteransprüchen angegeben.

Bei dem erfindungsgemäßen Gerät ist eines der Griffteile mit einem schwenkbaren Spitzenteil ausgebildet, an welchem die Kontaktspitze und die Aufnahme angeordnet sind. Das Gerät mit den ineinander gesteckten Kontaktspitzen kann zusammengeklappt werden, so daß das unbenutzte Gerät kompakt ist und platzsparend untergebracht werden kann. Insbesondere kann es in dem zusammengeklappten Zustand bequem in eine Kleidungsoder Gürteltasche geschoben werden.

Die Kontaktspitzen können in den zugeordneten Aufnahmen reibschlüssig gehalten werden. Zweckmäßigerweise sind die Kontaktspitzen und die Aufnahmen jedoch mit einer Rasteinrichtung ausgebildet, so daß die Kontaktspitzen im zusammengesteckten Zustand einschnappend gehalten werden und ein unbeabsichtigtes Trennen zuverlässig verhindert wird.

Damit sich das abklappbare Spitzenteil bei der Verwendung des Geräts nicht verschwenkt, ist zweckmäßigerweise eine Arretierung vorgesehen, die das Spitzenteil zumindest in der Betriebsstellung arretiert. Diese Arretierung kann als kraftschlüssige Rastung ausgebildet sein, z. B. mit federbelasteten Rastkugeln, so daß das Spitzenteil unter Überwindung der Rastkraft abgeklappt werden kann, oder als formschlüssige Rastung, die das Spitzenteil formschlüssig in der aufgeklappten Betriebsstellung hält. Die formschlüssige Arretierung kann in einer für die bequeme Handhabung vorteilhaften Ausführung durch das Einstecken der Kontaktspitze des anderen Griffteils entriegelt werden, so daß das Gerät zusammengeklappt werden kann, sobald die Griffteile mit ihren Kontaktspitzen zusammengesteckt sind.

Nachfolgend wird die Erfindung anhand eines in der Zeichnung dargestellten Ausführungsbeispiels näher erläutert. Es zeigen
- Figur 1: eine Seitenansicht des Gerätes in der Betriebsstellung,
- Figur 2: eine Frontansicht des Gerätes,
- Figur 3: eine Seitenansicht des Gerätes im zusammengeklappten Zustand,
- Figur 4: eine erste Ausführung der Arretierung in einem Schnitt gemäß der Linie IV-IV in Figur 2 in vergrößerter Darstellung,
- Figur 5: eine Figur 2 entsprechende Teilansicht einer zweiten Ausführung der Arretierung und
- Figur 6: einen Schnitt gemäß der Linie VI -VI in Figur 5.

Das beispielsweise als Spannungs- und Durchgangsprüfer geeignete Gerät weist ein erstes Griffteil 10 und ein zweites Griffteil 12 auf, die durch ein flexibles Kabel 14 miteinander verbunden sind. Das erste Griffteil 10 weist eine Kontaktspitze 16 und das zweite Griffteil 12 eine Kontaktspitze 18 auf. Das erste Griffteil 10 ist als Gehäuse ausgebildet, welches die elektronische Schaltung zum Messen und Prüfen der Spannung bzw. des Durchgangs, Anzeige- und Betätigungselemente 20 und eine Versorgungsbatterie aufnimmt. Die erste Kontaktspitze 16 ist in dem ersten Griffteil 10 und die zweite Kontaktspitze 18 ist über das Kabel 14 mit der in dem ersten Griffteil 10 aufgenommenen Schaltung verbunden. Insoweit ist das Gerät in an sich bekannter Weise aufgebaut. Insbesondere ist die Art des Messens und/oder Prüfens und die hierzu verwendete Schaltung an sich bekannt und nicht Gegenstand der Erfindung, so daß deren Einzelheiten nicht beschrieben werden müssen.

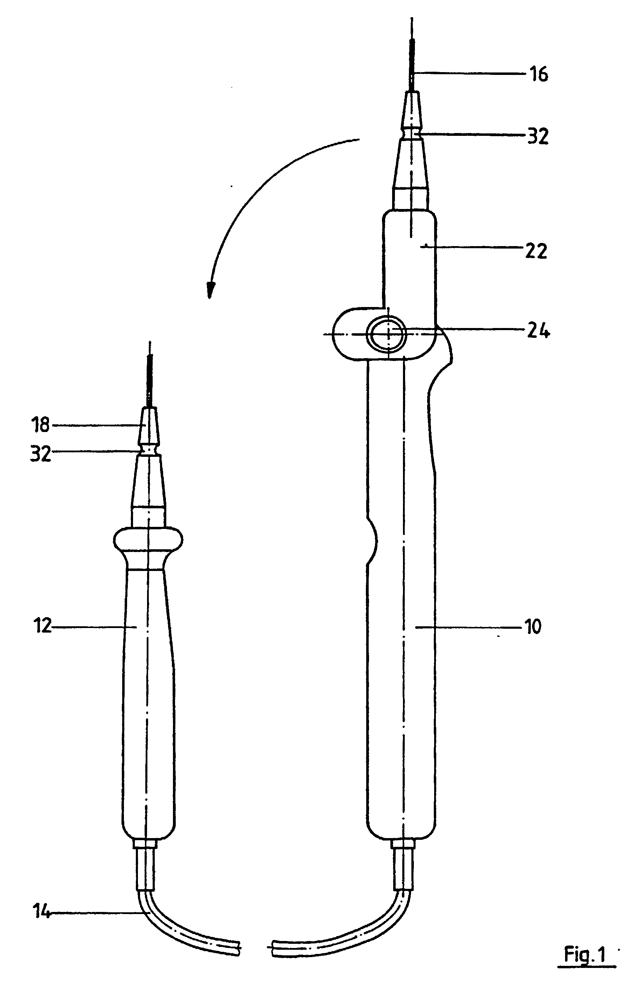

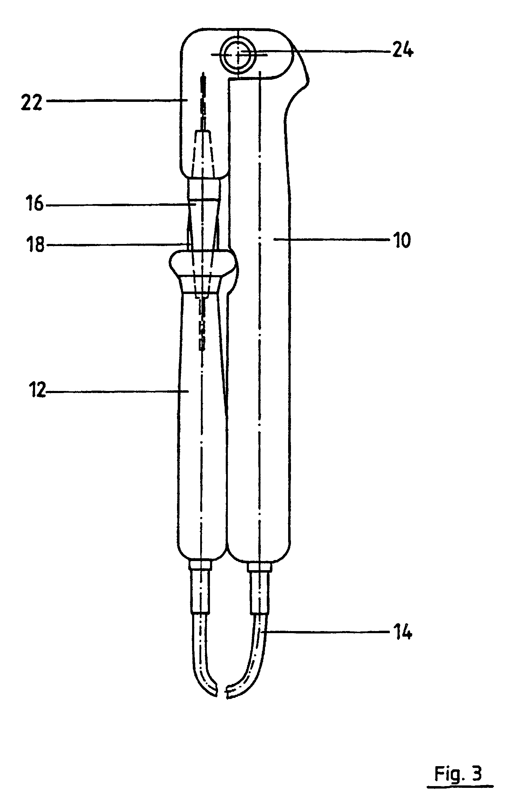

Das erste Griffteil 10 weist an seinem dem Anschluß des Kabels 14 entgegengesetzten Ende ein Spitzenteil 22 auf, welches um ein Gelenk 24 gegen das erste Griffteil 10 schwenkbar ist. Die Schwenkachse 56 des Gelenkes 24 verläuft quer zur Längserstreckung des ersten Griffteils 10. Das Spitzenteil 22 kann mittels des Gelenkes 24 in eine in Figur 1 gezeigte Betriebsstellung aufgeklappt werden, in welcher das Spitzenteil 22 in geradliniger Verlängerung des Griffteiles 10 angeordnet ist. Aus dieser Betriebsstellung kann das Spitzenteil 22, wie dies in Figur 1 durch einen Pfeil angedeutet ist, um 180° in eine Ruhestellung abgeklappt werden, die in Figur 3 dargestellt ist. In der Ruhestellung liegt das Spitzenteil 22 an der Flachseite des Griffteiles 10 an. Die elektrische Verbindung der in dem schwenkbaren Spitzenteil 22 angeordneten Kontaktspitze 16 mit der in dem Griffteil 10 angeordneten Schaltung erfolgt über eine flexible Ader, einen Schleifkontakt o. dgl.

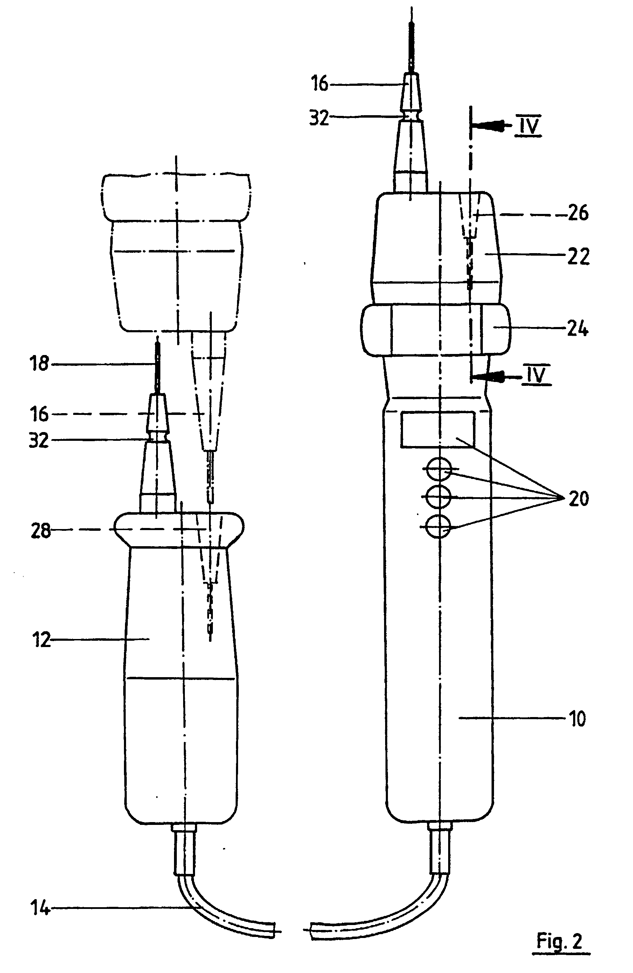

Die erste Kontaktspitze 16 ist asymmetrisch in der dem Gelenk 24 entgegengesetzten Stirnfläche des Spitzenteiles 22 angeordnet. Ebenso ist die zweite Kontaktspitze 18 asymmetrisch in der dem Anschluß des Kabels 14 entgegengesetzten Stirnfläche des zweiten Griffteils 12 angeordnet. Neben der ersten Kontaktspitze 16 ist achsparallel zu dieser Kontaktspitze 16 eine erste Aufnahme 26 in der Stirnfläche des Spitzenteils 22 vorgesehen. Entsprechend ist in der Stirnfläche des zweiten Griffteiles 12 neben der Kontaktspitze 18 achsparallel zu dieser eine zweite Aufnahme 28 vorgesehen. Die zweite Aufnahme 28 entspricht in ihrer Form der ersten Kontaktspitze 16 während die erste Aufnahme 26 in ihrer Form der zweiten Kontaktspitze 18 entspricht. Die Aufnahmen 26 und 28 sind in einem solchen Abstand neben den Kontaktspitzen 16 bzw. 18 angeordnet, daß die erste Kontaktspitze 16 des ersten Griffteils 10 in die zweite Aufnahme 28 des zweiten Griffteils 12 und die zweite Kontaktspitze 18 des zweiten Griffteils 12 in die erste Aufnahme 26 des ersten Griffteils 10 eindringt, wenn die beiden Griffteile 10 und 12 mit antiparallel gegeneinander gerichteten Kontaktspitzen 16 und 18 zusammengesteckt werden, wie dies in Figur 2 strichpunktiert angedeutet ist.

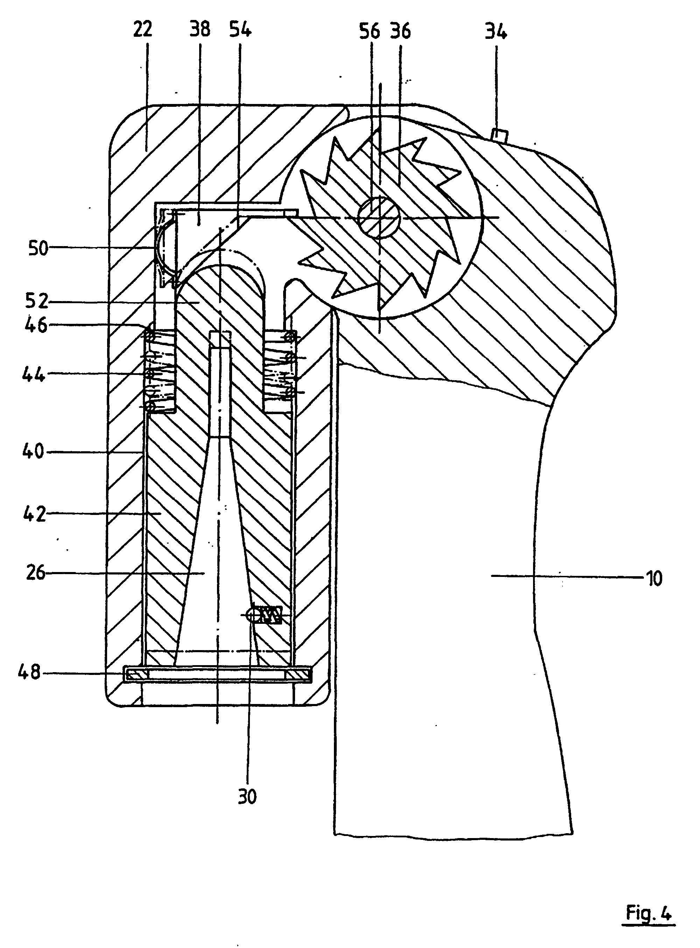

Die Kontaktspitzen 16 und 18 und die Aufnahmen 26 und 28 weisen vorzugsweise eine Rasteinrichtung auf, welche die in die Aufnahme 26 bzw. 28 eingesteckte Kontaktspitze 16 bzw. 18 in der Aufnahme 26 bzw. 28 kraftschlüssig hält. Die Rasteinrichtung kann beispielsweise eine federbelastete Kugel 30 sein, wie dies in Figur 4 für die erste Aufnahme 26 dargestellt ist, die in eine entsprechende Rastrille 32 der Kontaktspitze 16 bzw. 18 einrastet.

In der in Figur 1 gezeigten Betriebsstellung wird das Spitzenteil 22 in seiner mit dem ersten Griffteil 10 fluchtenden Stellung arretiert, so daß es sich auch bei Belastung während des Gebrauchs nicht gegen das erste Griffteil 10 verschwenken kann. Hierzu dient einerseits ein an dem ersten Griffteil 10 angeformter Anschlag 34, der ein Verschwenken des Spitzenteils 22 über die Streckstellung der Figur 1 hinaus verhindert. Anderseits weist die Arretierung eine Rastung auf, die ein Abklappen des Spitzenteils 12 aus der Streckstellung der Figur 1 verhindert.

In einem in Figur 4 gezeigten Ausführungsbeispiel ist die Arretierung als formschlüssige Rastung ausgebildet. Die Rastung weist ein koaxial zu dem Gelenk 24 fest in dem ersten Griffteil 10 angeordnetes Sperrad 36 und einen in dem Spitzenteil 22 gelagerten Feststellkeil auf. Das Spitzenteil 22 weist ein in seiner Stirnfläche ausgebildetes Sackloch auf, in welchem axial verschiebbar eine Schiebehülse 42 geführt ist. In der Schiebehülse ist die erste Aufnahme 26 ausgebildet. Die Schiebehülse 42 wird von einer Schraubendruckfeder 44, die sich an einer Innenschulter 46 des Sackloches abstützt, an einem in das Sackloch 40 eingesetzten Sprengring 48 anliegend gehalten. Die Schiebehülse 42 kann gegen die Kraft der Schraubendruckfeder nach innen in das Sackloch 40 gedrückt werden.

Der Feststellkeil 38 sitzt auf dem inneren Boden des Sackloches 40 und ist quer zur Achse des Sackloches 40 ab verschiebbar. Ein an dem Feststellkeil 38 angebrachtes Federblatt 50 stützt sich an der Innenwand des Sackloches 40 und drückt den Feststellkeil 38 durch einen Wanddurchbruch des Sackloches 40 hindurch, so daß er in die Zahnung des Sperrrades 36 eingreift. Am Innenende der Schiebehülse 42 ist ein Stößel 52 angeformt, der an einer Schrägen 54 des Feststellkeiles 38 angreift. Die Schräge 54 weist einen Neigungswinkel kleiner als 45° gegenüber der Achse der Schiebehülse 42 auf und steigt von dem in das Sperrad 36 eingreifenden Ende zu dem mit dem Federblatt 50 versehenen Ende des Feststellkeiles 38 an. Die Zahnung des Sperrades 36 ist als Ratschenzahnung ausgebildet, d. h. die Zähne des Sperrades weisen eine flach ansteigende und eine radial verlaufende Zahnflanke auf.

In der in Figur 4 gezeigten Ruhestellung wird die Schiebehülse 42, die die zweite Kontaktspitze 18 des zweiten Griffteiles 12 aufnimmt, durch die Schraubendruckfeder 44 an dem Sprengring 48 anliegend gehalten. Das Federblatt 50 drückt den Feststellkeil 38 in das Sperrad 36, so daß das Spitzenteil 22 in der in Figur 4 gezeigten Stellung gehalten wird. Die Kontaktspitzen 16 und 18 werden in den jeweiligen Aufnahmen 26 und 28 mittels der Rasteinrichtungen der Kugel 30 und der Rastrillen 32 gehalten. Das Gerät ist somit in der in Figur 3 gezeigt zusammengeklappten Stellung verrastet und kann sicher, bequem und platzsparend transportiert werden.

Soll das Gerät benutzt werden, so wird das zweite Griffteil 12 von dem ersten Griffteil 10 abgeschwenkt und nimmt dabei über die in die Aufnahmen 26 bzw. 28 eingesteckten Kontaktspitzen 16 und 18 das Spitzenteil 22 mit, das somit im Uhrzeigersinn (in Figur 4) gegen das erste Griffteil 10 verschwenkt wird. Bei dieser Schwenkbewegung kann der Feststellkeil 38 gegen die Kraft des Federblattes 50 über die flachansteigenden Zahnflanken des Sperrades 36 gleiten. Hat das Spitzenteil 22 die gestreckte Betriebsstellung erreicht, so verhindert der Anschlag 34 ein weiteres Schwenken des Spitzenteils 22. Der Feststellkeil 38 rastet unter der Kraft des Federblattes 50 hinter dem Zahn des Sperrades 36 ein, der im Figur 4 dem Feststellkeil 38 diametral gegenüber angeordnet ist. Die radiale Zahnflanke des Sperrades 36 wirkt nun mit dem Feststellkeil 38 zusammen und verhindert formschlüssig ein Zurückschwenken des Spitzenteils 22 im Gegenuhrzeigersinn. Das zweite Griffteil 12 kann nun von dem ersten Griffteil 10 gegen die Rastwirkung der Kugel 30 und der Rastrillen 32 abgezogen werden, so daß das Gerät einsatzbereit ist.

Soll das Gerät wieder in seiner Ruhestellung gebracht werden, so werden die Kontaktspitzen 16 und 18 wieder in die Aufnahmen 26 und 28 eingeführt. Dabei wird mit der in der ersten Aufnahme 26 sitzenden zweiten Kontaktspitze 18 des zweiten Griffteiles 12 ein axialer Druck auf die Schiebehülse 42 ausgeübt. Dadurch wird die Schiebehülse 42 gegen die Kraft der Schraubendruckfeder 44 in dem Sackloch 40 nach innen geschoben und drückt mit ihrem Stößel 52 auf die Schräge 54 des Feststellkeiles 38. Der Feststellkeil 38 wird gegen die Kraft seines Federblattes 50 verschoben und kommt außer Eingriff von der Zahnung des Sperrades 36. Die Arretierung des Spitzenteils 22 ist damit entriegelt und das Spitzenteil 22 mit dem eingesteckten zweiten Griffteil 12 kann in die in Figur 3 gezeigte Ruhestellung geklappt werden. In dieser Ruhestellung wird der Druck auf die Schiebehülse 42 beendet, die Schiebehülse 42 wird durch die Schraubendruckfeder 44 wieder gegen den Sprengring 48 geschoben und das Federblatt 50 schiebt den Feststellkeil 38 wieder in Eingriff mit dem Sperrad 36.

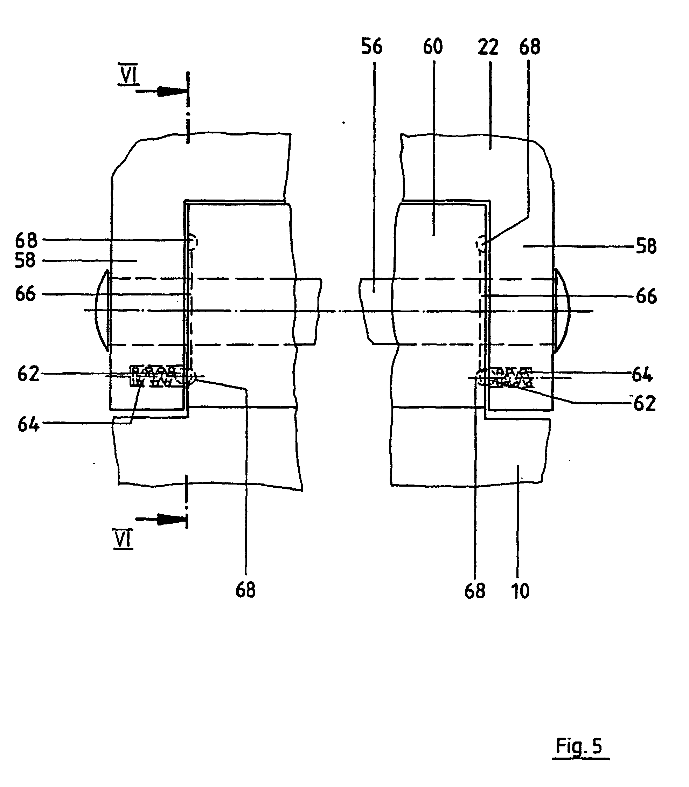

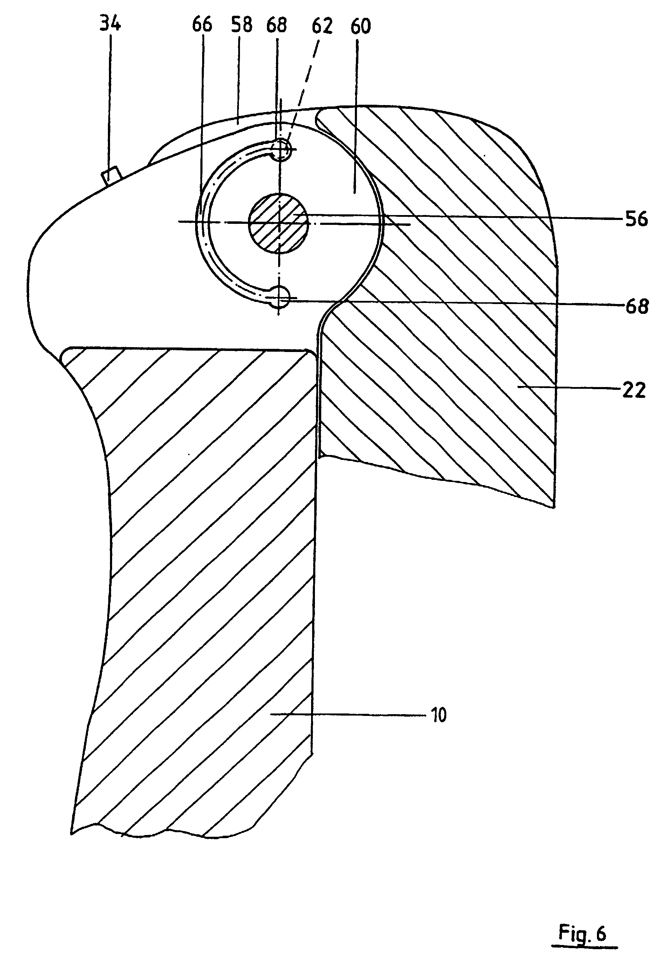

In den Figuren 5 und 6 ist eine zweite Ausführung der Arretierung dargestellt, bei welcher eine im wesentlichen kraftschlüssige Rastung vorgesehen ist. Hierzu sind das erste Griffteil 10 und das Spitzenteil 22 mit einem federbelasteten Rastglied und entsprechenden Rastaufnahmen ausgebildet. In dem zusammengeklappten Ruhezustand und in dem aufgeklappten gestreckten Betriebszustand rastet das Rastglied jeweils in eine entsprechend Rastaufnahme.

In dem dargestellten Ausführungsbeispiel ist das Gelenk 24, welches das Spitzenteil 22 mit dem Griffteil 10 verbindet, symmetrisch ausgebildet, wobei das Spitzenteil 22 mit vorspringenden Gelenkansätzen 58 beidseitig einen Gelenkansatz 60 des Griffteils umgreift. Die Gelenkansätze 58 des Spitzenteils 22 und der Gelenkansatz 60 des Griffteils 10 liegen jeweils mit axialen Stirnflächen aneinander an, die senkrecht zur Schwenkachse 56 verlaufen und von dieser Schwenkachse 56 mittig durchsetzt werden. In den Gelenkansätzen 58 des Spitzenteils 22 ist jeweils eine Rastkugel 62 gelagert, die von einer Druckfeder 64 beaufschlagt aus der axialen Stirnfläche herausragt. Die Rastkugeln 62 sind jeweils exzentrisch zur Schwenkachse 56 angeordnet. In den beiden axialen Stirnflächen des Gelenkansatzes 60 des Griffteiles 10 ist jeweils eine Laufrinne 66 für die zugeordnete Rastkugel 62 eingearbeitet. Die Laufrinnen 66 erstrecken sich über einen Halbkreis, dessen Radius bezogen auf die Schwenkachse 56 dem Radius der Rastkugeln 62 entspricht. An den beiden Enden der Laufrinne 66 ist jeweils eine vertiefte Rastaufnahme 68 vorgesehen. Die Winkelanordnung der Rastkugeln 62 in dem Spitzenteil 22 und der Laufrinne 66 mit den Rastaufnahmen 68 in dem Griffteil 10 ist so gewählt, daß die Rastkugeln 62 in zusammengeklapptem Ruhezustand unter dem Druck der Feder 64 in die eine Rastaufnahme einrasten, wie dies in Figur 6 dargestellt ist, während sie im aufgeklappten gestreckten Betriebszustand in die andere Rastaufnahme 68 einrasten, wie dies in Figur 5 dargestellt ist.

Im zusammengeklappten Ruhezustand und im aufgeklappten Betriebszustand ist das Spitzenteil 22 somit durch die einrastenden Rastkugeln 62 arretiert. Zum Aufklappen bzw. Zusammenklappen des Gerätes muß das Spitzenteil 22 gegen das Griffteil 10 mit einer solchen Kraft verschwenkt werden, daß die Rastkugeln 62 gegen die Kraft der Federn 64 aus den Rastaufnahmen 68 gedrückt werden. Beim Verschwenken des Spitzenteils 22 laufen die Rastkugeln 62 dann in den Laufrinnen 66.

## Patentansprüche

1. Gerät zum Prüfen und/oder Messen von elektrischen Größen, insbesondere von Spannungen und/oder Widerständen, mit zwei über ein flexibles Kabel (14) miteinander verbundenen Griffteilen (10, 12), die jeweils eine Kontaktspitze (16, 18) aufweisen, wobei jedes der Griffteile (10 bzw. 12) eine Aufnahme (26 bzw. 28) für die Kontaktspitze (18 bzw. 16) des jeweils anderen Griffteils (12 bzw. 10) aufweist, und wobei die Aufnahmen (26 bzw. 28) derart neben den Kontaktspitzen (16 bzw. 18) angeordnet sind, daß die Kontaktspitze (16 bzw. 18) des einen Griffteils (10 bzw. 12) jeweils antiparallel zur Kontaktspitze (18 bzw. 16) des anderen Griffteils (12 bzw. 10) in dessen Aufnahme (28 bzw. 26) einsteckbar ist,
**dadurch gekennzeichnet, daß** die Kontaktspitze (16) und die Aufnahme (26) des einen Griffteils (10) an einem Spitzenteil (22) angeordnet sind, welches um eine quer zur Längserstreckung des Griffteils (10) verlaufende Achse schwenkbar an dem Griffteil (10) angebracht ist.

2. Gerät nach Anspruch 1,
**dadurch gekennzeichnet, daß** zumindest eine der Kontaktspitzen (16 bzw. 18) in ihrer zugeordneten Aufnahme (28 bzw. 26) einrastbar (30, 32) ist.

3. Gerät nach Anspruch 1 oder 2,
**dadurch gekennzeichnet, daß** das schwenkbare Spitzenteil (22) zumindest in seiner aufgeklappten Betriebsstellung an dem Griffteil (10) arretierbar ist.

4. Gerät nach Anspruch 3,
**dadurch gekennzeichnet, daß** die Arretierung eine entriegelbare formschlüssige Rastung (36, 38) aufweist.

5. Gerät nach Anspruch 4,
**dadurch gekennzeichnet, daß** die formschlüssige Rastung (36, 38) durch die eingesteckte Kontaktspitze (18) des anderen Griffteils (12) entriegelbar ist.

6. Gerät nach Anspruch 5,
**dadurch gekennzeichnet, daß** in dem Griffteil (10) ein Sperrad (36) angeordnet ist, daß in dem Spitzenteil (22) ein in das Sperrad (36) eingreifendes Feststellelement (38) angeordnet ist und daß das Feststellelement (38) durch die Kontaktspitze (18) des anderen Griffteils (12) aus dem Sperrad (36) herausgehoben wird.

7. Gerät nach Anspruch 6,
**dadurch gekennzeichnet, daß** das Feststellelement ein Feststellkeil (38) mit einer Schräge (54) ist, daß die Aufnahme (26) des Spitzenteils (22) in einer in dem Spitzenteile (22) verschiebbar gelagerten Schiebehülse (42) ausgebildet ist und daß die Schiebehülse (42) durch die eingesetzte Kontaktspitze (18) verschiebbar ist und bei ihrer Verschiebung auf die Schräge (54) einwirkt und den Feststellkeil (38) aus dem Sperrad (36) heraushebt.

8. Gerät nach Anspruch 3,
**dadurch gekennzeichnet, daß** die Arretierung eine kraftschlüssige Rastung (62, 68) aufweist.

9. Gerät nach Anspruch 8,
**dadurch gekennzeichnet, daß** die kraftschlüssige Rastung zumindest ein federbelastetes Rastglied (62, 64) in dem Spitzenteil (22) bzw. in dem Griffteil (10) aufweist, welches zumindest in der aufgeklappten Betriebsstellung in eine entsprechende Rastaufnahme (68) des Griffteils (10) bzw. des Spitzenteils (22) einrastet.

## Claims

1. Instrument for testing and/or measuring of electric variables, in particular voltages and/or resistances, with two handle parts (10, 12), which are connected to each other via a flexible cable (14) and each of which has a contact point (16, 18), each of the handle parts (10 and 12) having a receptacle (26 and 28, respectively) for the contact point (18 and 16, respectively) of the other handle part (12 and 10, respectively), and the receptacles (26 and 28, respectively) being arranged next to the contact points (16 and 18, respectively) in a way such that the contact point (16 or 18) of one handle part (10 or 12) can be plugged into the receptacle (28 or 26) of the other handle part (12 or 10) in an antiparallel manner with respect to the contact point (18 or 16) of the said other handle part, **characterised in that** the contact point (16) and the receptacle (26) of one handle part (10) are arranged on a point part (22) which is mounted on the handle part (10) in such a way as to be pivotable about an axis extending transversely to the longitudinal extent of the handle part (10).

2. Instrument according to Claim 1, **characterised in that** at least one of the contact points (16 or 18) can be latched (30, 32) in its associated receptable (28 or 26).

3. Instrument according to Claim 1 or 2, **characterised in that** the pivotable point part (22) can be locked on the handle part (10) at least in its unfolded operating position.

4. Instrument according to Claim 3, **characterised in that** the locking arrangement has a releasable, form-locking latching arrangement (36, 38).

5. Instrument according to Claim 4, **characterised in that** the form-locking latching arrangement (36, 38) is releasable by the inserted contact point (18) of the other handle part (12).

6. Instrument according to Claim 5, **characterised in that** a locking wheel (36) is arranged in the handle part (10), **in that** a locking element (38) engaging in the locking wheel (36) is arranged in the point part (22), and **in that** the locking element (38) is lifted out of the locking wheel (36) by the contact point (18) of the other handle part (12).

7. Instrument according to Claim 6, **characterised in that** the locking element is a locking wedge (38) with a bevel (54), **in that** the receptacle (26) of the point part (22) is formed in a sliding sleeve (42) displaceably supported in the point part (22), and **in that** the sliding sleeve (42) is displaceable by the inserted contact point (18) and, during its displacement, acts upon the bevel (54) and lifts the locking wedge (38) out of the locking wheel (36).

8. Instrument according to Claim 3, **characterised in that** the locking arrangement has a force-locking latching arrangement (62, 68).

9. Instrument according to Claim 8, **characterised in that** the force-locking latching arrangement has at least one spring-loaded latching member (62, 64) in the point part (22) or the handle part (10), said member engaging in a matching latching receptacle (68) of the handle part (10) or the point part (22), at least in the unfolded operating position.

## Revendications

1. Appareil pour tester et/ou mesurer des grandeurs électriques, en particulier des tensions et/ou des résistances, dans lequel :
- deux parties de saisie (10, 12) reliées entre elles par un câble flexible (14) présentent chacune une pointe de contact (16, 18) ainsi qu'un logement (26, 28) pour accueillir la pointe de contact (18, 16) de l'autre partie de saisie (12, 10),
- les logements (26, 28) sont disposés à côté des pointes de contact (16, 18) de manière que la pointe de contact (16, 18) d'une partie de saisie (10, 12) peut être emmanchée dans le logement correspondant (28, 26) de l'autre partie de saisie (12, 10) avec antiparallélisme des pointes de contact (18, 16),
**caractérisé en ce que**
la pointe de contact (16) et le logement (26) d'une partie de saisie (10) sont montés sur une partie à pointe (22) qui peut basculer autour d'un axe perpendiculaire à la dimension longitudinale de cette partie de saisie (10).

2. Appareil selon la revendication 1,
**caractérisé en ce qu'**
au moins une des pointes de contact (16, 18) peut être encliquetée (30, 32) dans le logement (28, 26) qui lui est associé.

3. Appareil selon l'une quelconque des revendications 1 ou 2,
**caractérisé en ce que**
la partie à pointe (22) basculante, au moins dans sa position relevée de service, peut être bloquée sur la partie de saisie (10).

4. Appareil selon la revendication 3,
**caractérisé en ce que**
le dispositif de blocage comprend un encliquetage (36, 38) par combinaison de formes, déverrouillable.

5. Appareil selon la revendication 4,
**caractérisé en ce que**
l'encliquetage par combinaison de formes (36, 38) peut être déverrouillé en emmanchant la pointe de contact (18) de l'autre partie de saisie (12).

6. Appareil selon la revendication 5,
**caractérisé en ce que**
dans la partie de saisie (10) est montée une roue d'arrêt (36) et dans la partie à pointe (22) est monté un élément de fixation (38) qui est engagé dans la roue d'arrêt (36) et en est libéré par la pointe de contact (18) de l'autre partie de saisie (12).

7. Appareil selon la revendication 6,
**caractérisé en ce que**
l'élément de fixation est un coin d'immobilisation (38) présentant un chanfrein (54), le logement (26) de la partie à pointe (22) est réalisé dans une douille (42) montée coulissante dans une des parties à pointe (22), cette douille coulissante (42) se déplace quand on introduit la pointe de contact (18) et en agissant sur le chanfrein (54) dégage de la roue d'arrêt (36) le coin d'immobilisation (38).

8. Appareil selon la revendication 3,
**caractérisé en ce que**
le dispositif de blocage présente un accrochage à force (62, 68).

9. Appareil selon la revendication 8,
**caractérisé en ce que**
l'accrochage à force présente dans la partie à pointe (22) et dans la partie de saisie au moins un organe d'accrochage (62, 64) chargé par un ressort et qui, au moins en position enclenchée de service, est encliqueté dans un logement d'accrochage (68) de la partie de saisie (10) ou de la partie à pointe (22).
